Europäisches Patentamt

European Patent Office

Office européen des brevets

(11) Publication number: **0 457 131 A1**

# EUROPEAN PATENT APPLICATION

(21) Application number: 91107197.5

(51) Int. Cl.5: **H01L 27/108, H01L 21/82**

(22) Date of filing: **03.05.91**

(30) Priority: **18.05.90 JP 126794/90**

(43) Date of publication of application:
**21.11.91 Bulletin 91/47**

(84) Designated Contracting States:
**DE FR GB**

(71) Applicant: **Kabushiki Kaisha Toshiba**
**72, Horikawa-cho Saiwai-ku**
**Kawasaki-shi(JP)**

(72) Inventor: **Kohyama, Yusuke, c/o Intellectual**
**Property Div.**
**K.K. TOSHIBA, 1-1 Shibaura 1-chome**
**Minato-ku, Tokyo 105(JP)**

(74) Representative: **Lehn, Werner, Dipl.-Ing. et al**
**Hoffmann, Eitle & Partner Patentanwälte**
**Arabellastrasse 4**
**W-8000 München 81(DE)**

(54) **Method of manufacturing semiconductor memory device having stacked capacitor cells.**

(57) This invention relates to a method of manufacturing a semiconductor memory device having stacked capacitor cells. Bit lines (7) of the stacked capacitor cells are filled in grooves (3) formed in the main surface area of a substrate (1) and the bit line (7) has an area which is exposed from the groove (3). An insulation film (8) is formed on the area. In this invention, the insulation film (8) is formed in the following manner. First, a nitride film (5) is formed on the main surface of the substrate (1) and the side and bottom surfaces of each of the grooves (3). Then, the internal portion of the groove (3) is filled with a conductive film (7) to form a bit line. After this, the surface portion of the bit line is oxidized with the nitride film (5) used as a mask. The insulation film (8) can be formed by this oxidation.

F I G. 4I

This invention relates to a method of manufacturing a semiconductor memory device, and more particularly to a method of manufacturing a semiconductor memory device having a stacked capacitor cell structure in which bit lines are buried in a substrate.

The integration density and memory capacity of a DRAM in which each memory cell is formed of one transistor and one capacitor are rapidly increased with the progress of fine patterning technique. Use of a stacked capacitor cell structure is known as a method of increasing the capacitances of capacitors in the DRAM.

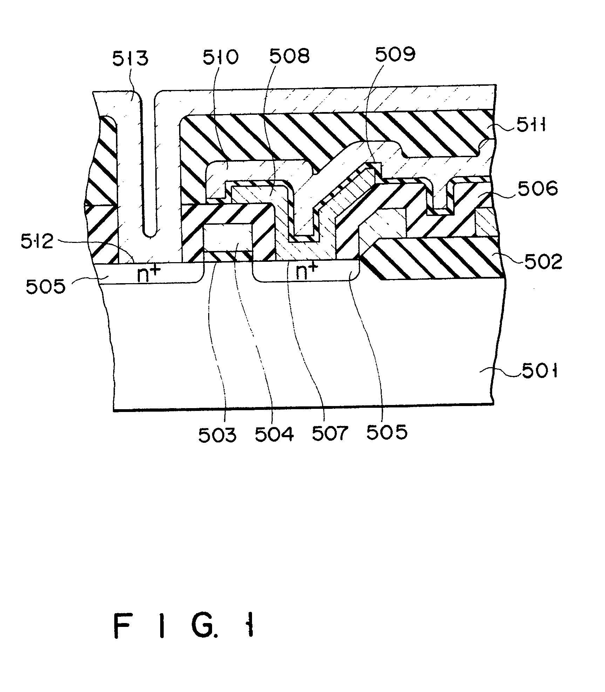

Fig. 1 is a cross sectional view of the conventional stacked capacitor cell taken along a bit line direction.

In order to form the stacked capacitor cell, a field oxide film 502 serving as an element isolation region is formed on a P-type silicon substrate 501 by local oxidation of silicon. After this, a gate oxide film 503, gate electrode 504 and source/drain diffused regions 505 are formed to constitute a transfer transistor. Further, an interlevel insulater 506 is disposed on the resultant structure and a storage node electrode 508 with a film thickness of 3000 Å, for example, is formed of phosphorus doped polysilicon in a contact hole 507 formed in the interlevel insulater 506. In order to electrically connect the storage node electrode 508 to the source/drain diffused regions 505, phosphorus is generally ion implanted into the substrate 501 and storage node electrode 508 to approx. $1 \times 10^{16}$ cm$^{-2}$ (dose).

Then, a plate electrode 510 is formed of phosphorus doped polysilicon to a film thickness of 3000 Å, for example, with a capacitor dielectric film 509 disposed between the plate electrode 510 and the storage node electrode 508 and the like so as to form a stacked capacitor. After this, an interlevel insulater 511 is formed on the resultant structure and a contact hole 512 is continuously formed in the interlevel insulaters 511 and 506. A bit line which is connected to the drain region 505 via the contact hole 512 is formed of a molybdenum silicide film 513, for example.

The DRAM stacked capacitor cell is formed through the above manufacturing process.

When the DRAM having the above stacked capacitor cell is formed with a high integration density, the following problems may occur.

That is, since the contact hole 512 is formed after the transfer transistor is formed and the stacked capacitor cell is formed, and then the bit line is connected to the drain region 505, it is necessary to form a deep contact hole, thus increasing the step in level of the bit line.

An object of this invention is to provide a method of manufacturing a semiconductor memory device having memory cells capable of attaining even higher integration density.

The above object can be attained by the following manufacturing method.

First, grooves are formed in the main surface area of a substrate. Then, an oxidation-resistant film is formed on the main surface of the substrate and the side and bottom surfaces of the grooves. After this, a conductive film is formed to fill the internal spaces of the grooves so as to construct bit lines. Then, the surface of the bit lines exposed from the grooves are oxidized with the oxidation-resistant film used as a mask so as to form an insulation film on the surface of each of the bit lines.

According to the above manufacturing method, a structure in which the bit lines are buried in the grooves formed in the main surface area of the substrate is obtained and therefore a memory cell capable of attaining even higher integration density can be obtained. In the process of forming the above memory cell, part of the surface of the bit line is exposed from the groove. The insulation film is formed on the area exposed from the groove in order to isolate the bit line from the remaining portion. At the time of forming the insulation film, the surface of the area exposed from the groove is oxidized with the oxidation-resistant film used as a mask since the oxidation-resistant film is formed on the main surface of the substrate and the side and bottom surfaces of the groove. By effecting the above oxidation process, the insulation film having a sufficiently large film thickness for isolating the bit line from the remaining portion can be formed on the area exposed from the groove. Further, in the step of forming the insulation film, a new insulation film will not be formed on the main surface of the substrate because the main surface of the substrate is covered with the oxidation-resistant film.

This invention can be more fully understood from the following detailed description when taken in conjunction with the accompanying drawings, in which:

Fig. 1 is a cross sectional view of a conventional stacked capacitor cell;

Figs. 2A to 2I are plan views showing the manufacturing method in the order of the steps for manufacturing a stacked capacitor cell according to a first embodiment of this invention;

Figs. 3A to 3G are cross sectional views taken along the lines 3A-3A to 3G-3G of Figs. 2A to 2G, respectively;

Fig. 3H is a cross sectional view taken along the line 3H-3H of Fig. 2I;

Figs. 4A to 4I are cross sectional views taken along the lines 4A-4A to 4I-4I of Figs. 2A to 2I, respectively;

Figs. 5A and 5B are cross sectional views taken along the lines 5A-5A and 5B-5B of Figs. 2H and 2I, respectively;

Fig. 6A is a cross sectional view taken along the line 6A-6A of Fig. 2I; and

Figs. 7A to 7D are plan views showing the manufacturing method in the order of the steps for manufacturing a stacked capacitor cell according to a second embodiment of this invention.

There will now be described an embodiment of this invention with reference to the accompanying drawings.

[First embodiment]

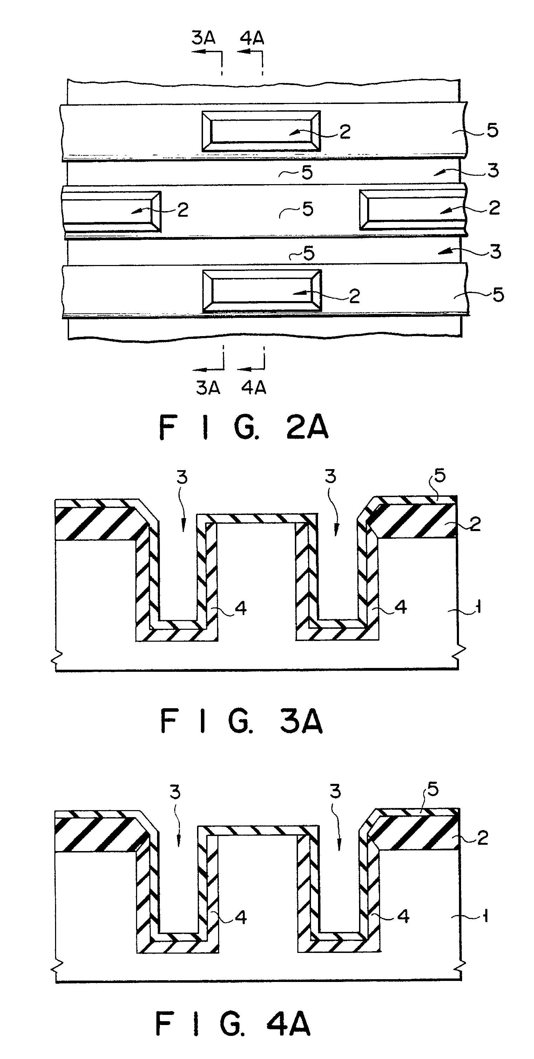

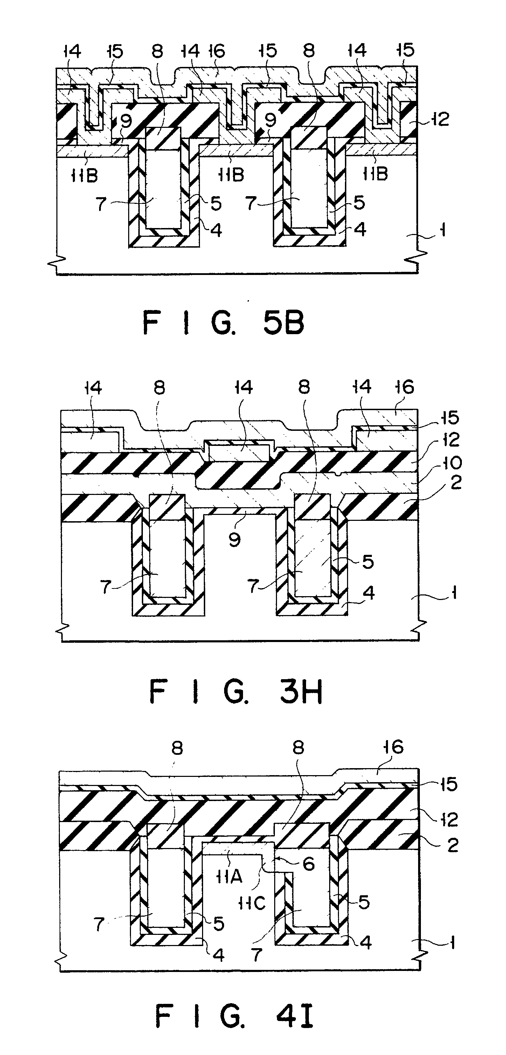

A method of manufacturing a semiconductor memory device according to a first embodiment of this invention is explained with reference to Figs. 2A to 2I, Figs. 3A to 3H, Figs. 4A to 4I, Fig. 5A, Fig. 5B and Fig. 6A.

First, a field oxide film 2 for element isolation is formed on the main surface of a P-type silicon substrate 1. Then, the substrate 1 is selectively etched to form grooves therein. Next, in order to form a first layer of insulation on the side and bottom surfaces of each of the grooves, an oxidation process is effected to form an oxide film 4 having a film thickness of approx. 500 to 2000 Å, for example. After this, an oxidation-resistant film (for example, silicon nitride film) 5 having a film thickness of approx. 500 Å, for example, is formed as a second layer on the resultant structure (Fig. 2A, 3A, 4A).

Next, a photoresist (not shown) is used as a mask to selectively etch portions of the silicon nitride film 5 and the oxide films 4 formed on the side surfaces of the grooves 3 so as to form bit line contact windows 6 (Figs. 2B, 3B, 4B).

Further, the bit line contact windows 6 may be formed by simultaneously etching the silicon nitride film 5 and the oxide films 4, or may be formed by first etching the silicon nitride film 5, removing the photoresist and then selectively etching the oxide films 4 with the silicon nitride film 5 used as a mask.

Next, a conductive film (for example, phosphorus doped polysilicon film) is formed as a third layer on the resultant structure. Then, the conductive film is etched back by the RIE method, for example, so as to be left behind in each of the grooves. As a result, the conductive film which is left behind in each of the grooves 3 constitutes a bit line 7 (Figs. 2C, 3C, 4C).

N-type diffused layers 11C are formed in the substrate 1 by diffusing N-type impurity into the substrate 1 via the windows 6 in order to connect the bit lines to the respective sources/drains of transfer transistors in the later step. For example, a method of forming the above layers is effected by ion-implanting N-type impurity into the substrate 1 via the windows 6 after the windows have been formed. After this, the ion-implanted impurity is diffused into the substrate 1 to form the N-type diffused layers 11C. Another method of forming the above layers is effected by filling the grooves 3 with conductive films constituting the bit lines 7 and then diffusing N-type impurity contained in the conductive films into the substrate 1 via the windows 6 so as to form the N-type diffused layers 11C.

Next, a thermal oxidation process is effected to form oxide films 8 as a fourth film on the exposed upper surface of the respective bit lines 7. As a result, the surface of each of the bit lines 7 is covered with insulative material and isolated from the other portion. At this time, since all the portion (including a portion in which an oxide film used for forming a gate insulation film of a transfer gate transistor is formed in the later step) of each of the bit lines 7 except the exposed portion is covered with the silicon nitride film 5, it will not be oxidized (Figs. 2D, 3D, 4D).

Next, the silicon nitride film 5 is removed with the oxide films 8 on the upper surface of the bit lines 7 used as a mask so as to expose those portion of the main surface of the silicon substrate 1 which lie in the element forming areas. In the process of removing the silicon nitride film 5, for example, phosphoric acid is used. In another method, it is possible to use gas having a high selective etching ratio for the oxide film 8 and the silicon nitride film 5 and then subject the silicon nitride film 5 to dry etching (Figs. 2E, 3E, 4E).

Further, if a pad oxide film (not shown) is previously formed on the main surface of the substrate 1, the silicon substrate 1 can be prevented from being etched when the above silicon nitride film 5 is etched. Since the film thickness of the pad oxide film can be set to be sufficiently smaller than that of the oxide film 8 serving as the fourth layer, the film thickness of the oxide film 8 can be kept large enough to insulatively isolate the bit line 7 from the remaining portion even if the pad oxide film is removed by subjecting all the surface of the resultant structure to the etching process by use of solution such as HF buffer solution.

Next, thin gate oxide films 9 having a film thickness of approx. 100 Å, for example, are formed as a fifth layer of insulation on an area in which the main surface of the substrate 1 is exposed by the thermal oxidation process, for example (Figs. 2F, 3F, 4F).

Next, a conductive film (for example, phosphorus doped polysilicon film) having a film thickness of approx. 2000 Å is formed on the resultant structure. Then, the conductive film is patterned to form gate electrodes 10 of the transfer transistors. After this, for example, arsenic ions are ion-implanted into the substrate 1 by approx. $1 \times 10^{15}$ $cm^{-2}$ to form $N^+$-type diffused layers 11A and 11B for sources and drains of the above transistors (Figs. 2G, 3G, 4G).

Next, an insulation film 12 is formed on the resultant structure by the CVD method. Then, storage node contact windows 13 reaching the $N^+$-type diffused layers 11B which serve as sources, for example, are selectively formed in preset positions of the insulation film 12 with a photoresist used as a mask by the RIE method. After this, a conductive film (for example, phosphorus doped polysilicon film) is formed on the resultant structure and then patterned to form storage nodes 14 (Figs. 2H, 4H, 5A).

Next, for example, a combined film 15 of SiNx/SiO₂ is formed to a thickness of approx. 50 Å as a capacitor gate insulation film on the resultant structure. Then, a conductive film (for example, phosphorus doped polysilicon film) 16 is formed as a cell plate electrode on the resultant structure (Figs. 2I, 3H, 4I, 5B, 6A).

According to the manufacturing method described above, the bit lines 7 can be formed in a buried form in the substrate 1 when the stacked capacitor cells are formed. Further, when the oxide films 8 for insulatively isolating the bit lines 7 are formed on the upper surfaces of the bit lines 7, only the upper surface portions of the bit lines 7 can be selectively oxidized since all the areas of the bit lines 7 except the exposed portions are covered with the second layer (silicon nitride film 5). As a result, for example, the film thickness of the oxide films 8 can be freely set. That is, when the oxide films 8 are formed, areas in which the gate oxide films 9 are formed are not oxidized since they are covered with the nitride film 5. Since the gate oxide films 9 are formed after the nitride film 5 formed on the areas in which the gate oxide films 9 are to be formed is removed, the gate oxide films 9 having a small film thickness of approx. 100 Å, for example, can be formed with high controllability. When the nitride film 5 is removed, the oxide films 8 can be used as a mask so as to selectively remove the nitride film.

With the above manufacturing method, the gate oxide films 9 can be formed thin and the oxide films 8 for insulatively isolating the bit lines 7 can be formed thick, thereby further increasing the integration density.

Further, in the above embodiment, since the nitride film 5 is formed on the side and bottom surfaces of the grooves 3, the following advantages can be attained, for example. That is, when the selective oxidation is effected, a bird's beak is difficult to be formed between the nitride film 5 and the main surface of the substrate 1 on which the gate oxide films 9 are formed since the nitride film 5 is also formed on the side surfaces of the grooves 3. As a result, the oxide films 8 can be formed thicker.

[Second embodiment]

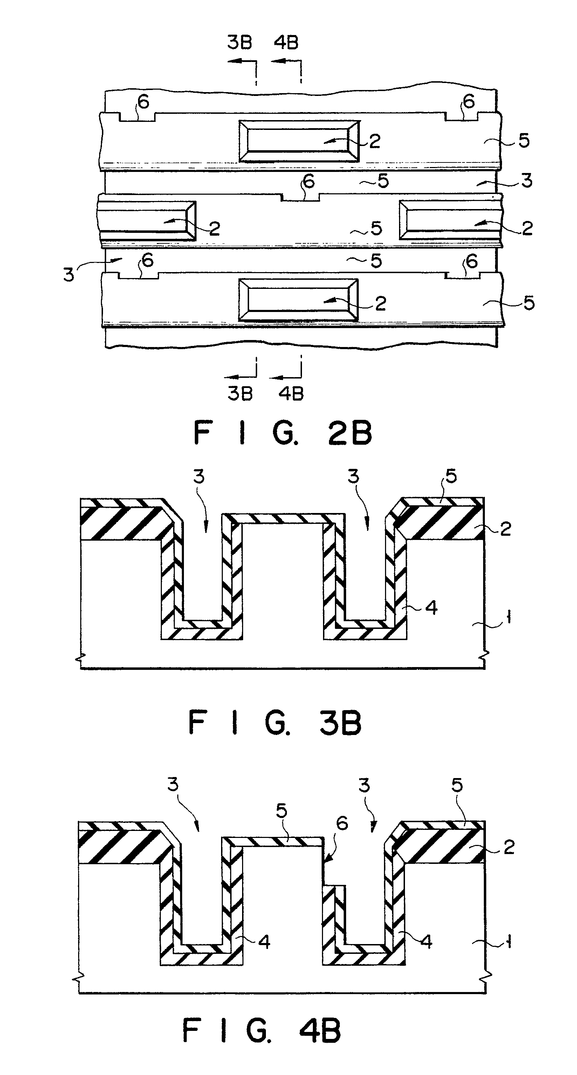

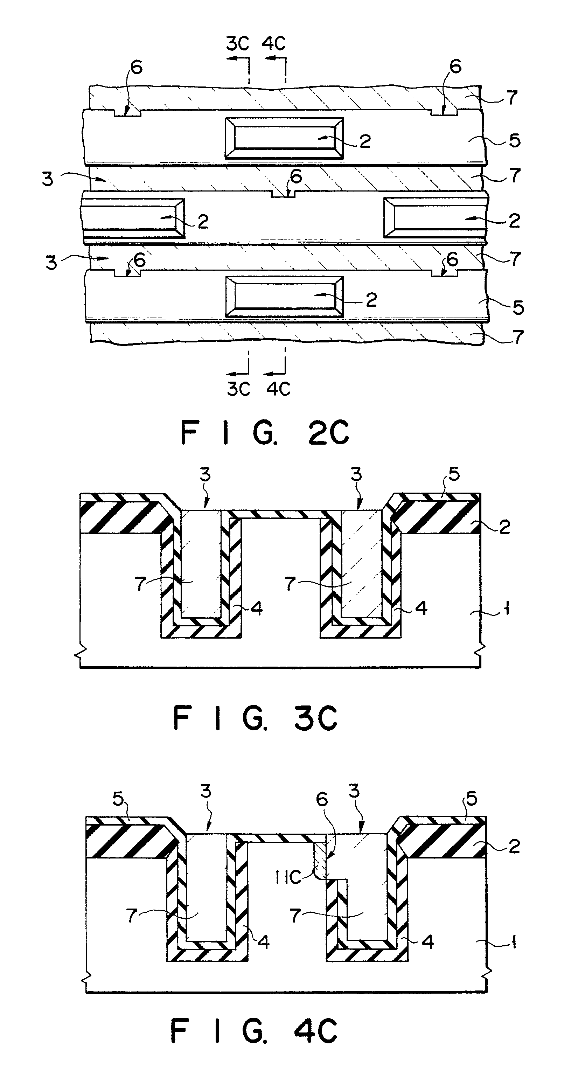

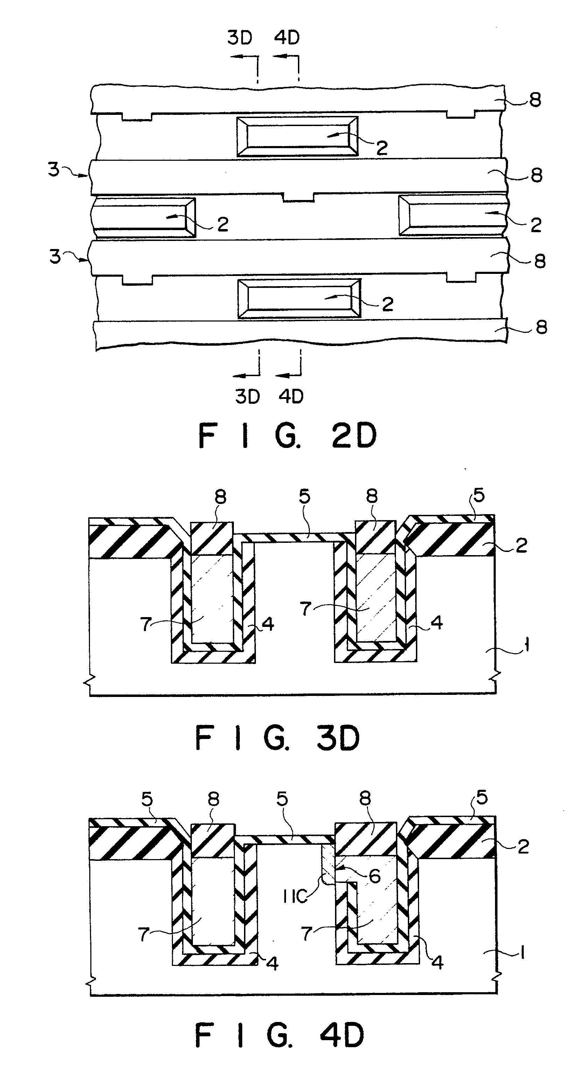

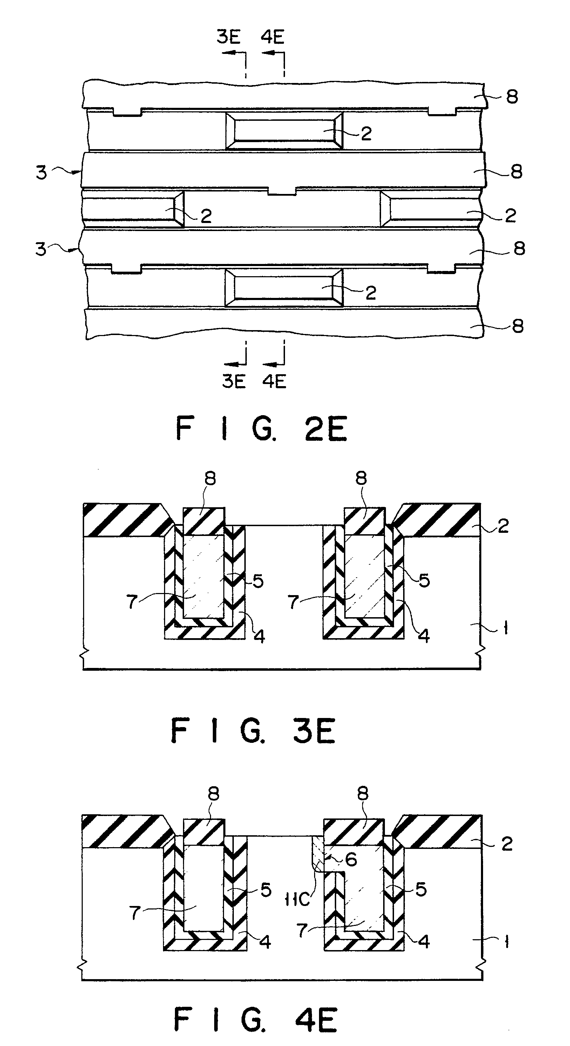

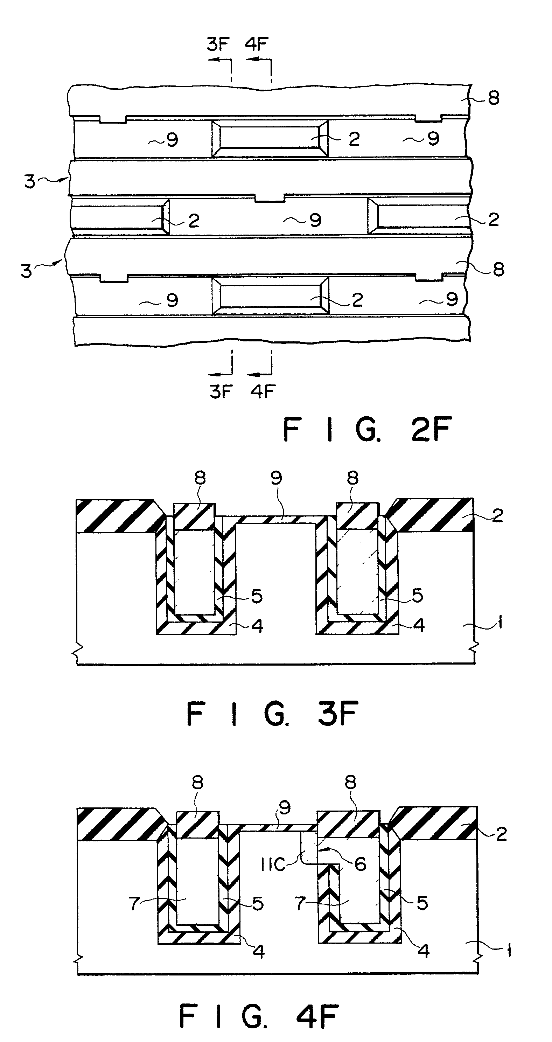

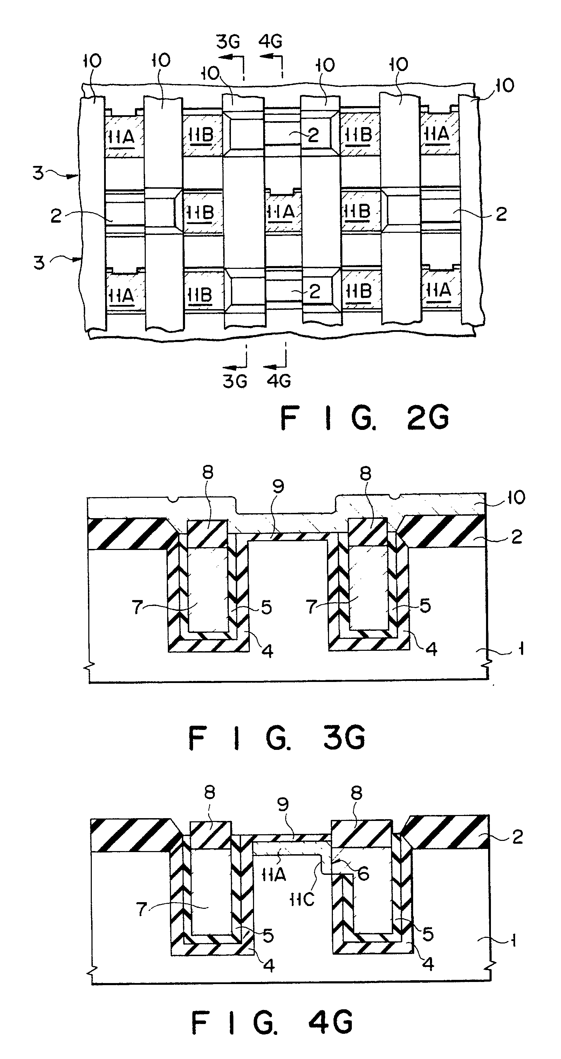

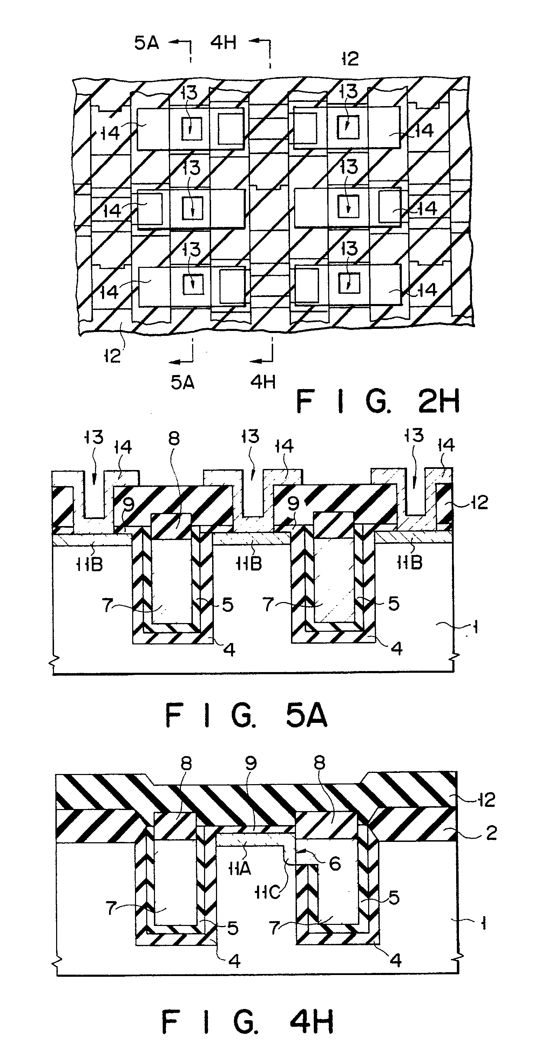

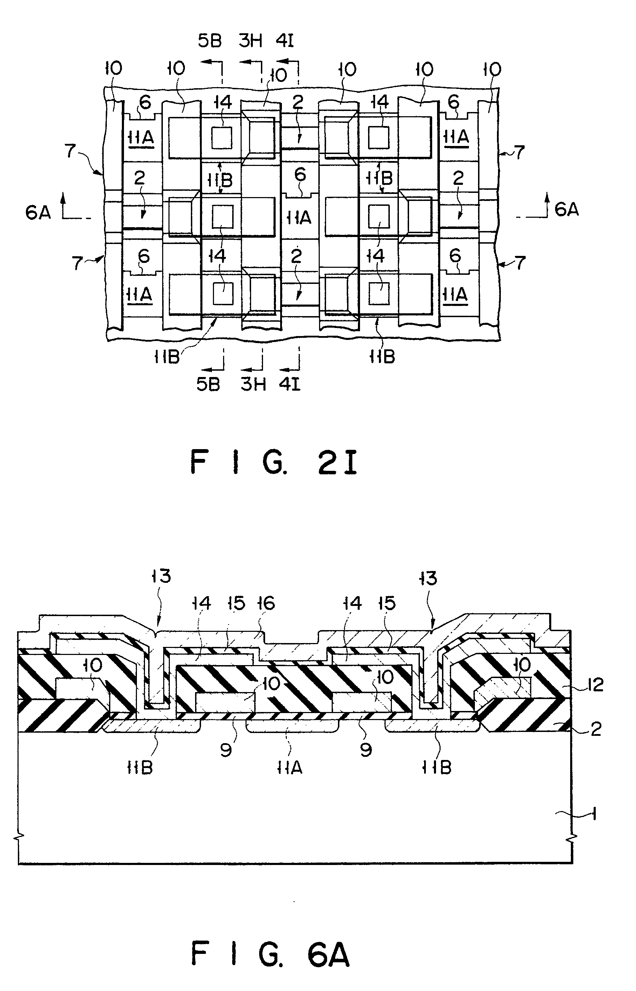

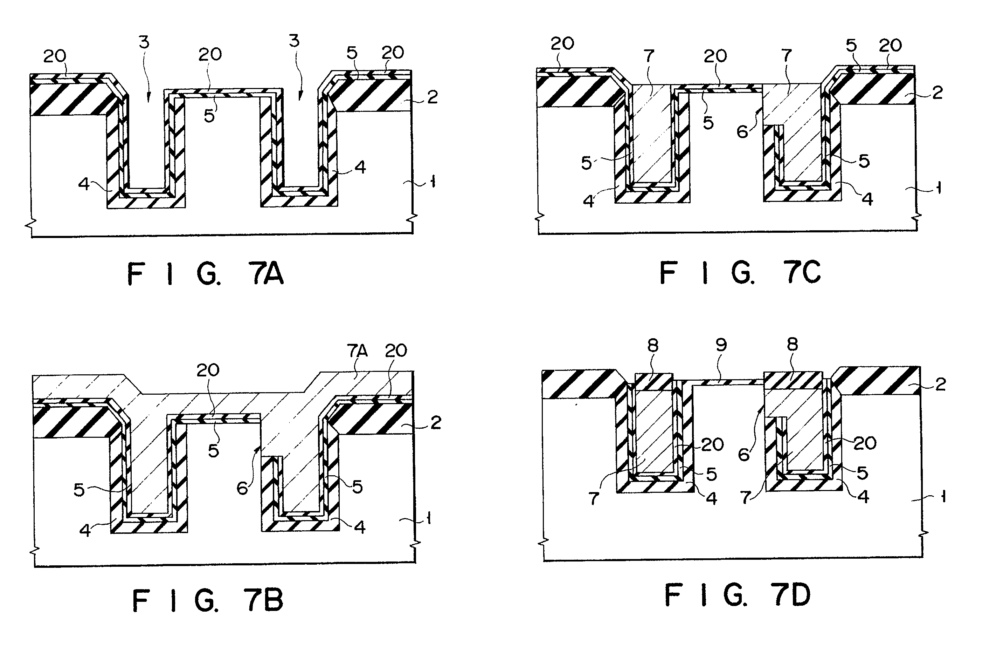

Figs. 7A to 7D are cross sectional views showing a semiconductor memory device manufacturing method in an order of the steps for manufacturing a semiconductor memory device according to a second embodiment of this invention. Figs. 7A to 7D show the cross sections of the same portion as that of the cross section shown in Fig. 4A, for example.

First, a silicon nitride film 5 is formed in the same manner as that explained with reference to Figs. 2A, 3A and 4A. Then, the surface of the silicon nitride film 5 is oxidized to form an oxide film 20, for example (Fig 7A).

Next, a photoresist (not shown) is used as a mask to selectively remove the oxide film 20, nitride film 5 and oxide film 4 formed on the side and bottom surfaces of grooves 3 so as to form bit line contact windows 6. Then, a conductive film (for example, phosphorus doped polysilicon film) 7A is formed on the resultant structure (Fig. 7B).

Next, the conductive film 7A is etched back by the CDE method, for example, so as to form bit lines 7 (Fig. 7C).

Then, a combined film of the oxide film 20 and the nitride film 5 is used as a mask to selectively oxidize only the upper surface portions of the bit lines 7 so as to form oxide films 8. After this, the oxide film 20 and the nitride films 8 formed on the surface of the silicon substrate 1 and the like are removed. Then, gate oxide films 9 are formed on the surface of the exposed substrate 1 (Fig. 7D).

After this, although not shown in the drawing, gate electrodes 10, storage nodes 14 and the like are sequentially formed in the same manner as explained with reference to Figs. 2G to 2I, for example.

With the above manufacturing method, when the phosphorus doped polysilicon film 7A is etched back so as to be left behind in the groove 3, the oxide film 20 acts as an etching stopper. That is, the nitride film 5 can be prevented from being removed from an area in which the gate oxide films are formed, for example, when the polysilicon film 7A is etched back by forming the oxide film 20 on the nitride film 5.

As described above, according to the semiconductor memory device manufacturing method of this invention, stacked capacitor cells in which bit lines are buried in the substrate can be obtained. When the insulation film for insulatively isolating the bit lines is formed, an area in which the gate oxide films are formed is covered with the oxidation-resistant film so that the surface of the bit lines exposed from the respective grooves can be selectively oxidized. Therefore, the insulation film for insulatively isolating the bit lines is formed on the surface of the bit lines exposed from the grooves and the film thickness thereof can be freely set. In other words, since it is prevented that the area in which the gate oxide films are to be formed is simultaneously oxidized and a thick oxide film is formed, a thin gate oxide film of approx. 100 Å, for example can be formed with high controllability. Further, the oxidation-resistant film can be selectively removed by using the insulation film for insulatively isolating the bit line as a mask. Therefore, the gate insulation film of the transfer transistor can be made thin and the insulation film for insulatively isolating the bit line can be made thick, thus permitting the integration density of the memory to be further enhanced.

This invention is not limited to the above first and second embodiments and can be variously modified without departing from the technical scope thereof.

For example, in the first and second embodiments, the oxide film is formed on the side and bottom surfaces of the groove and then the silicon nitride film is formed over the entire surface of the substrate. However, this method can also be attained by forming a nitride film over the entire surface of the substrate to cover the side and bottom surfaces of the grooves without forming an oxide film. Also, in this case, the surface of an area of the silicon substrate in which the gate oxide film is to be formed can be covered with the nitride film, and as described in the first and second embodiments, only the upper surface of the bit line filled in the groove can be selectively oxidized.

Reference signs in the claims are intended for better understanding and shall not limit the scope.

**Claims**

1. A method of manufacturing a semiconductor memory device having stacked capacitor cells, characterized by comprising the steps of:
   a) selectively etching a surface portion of a semiconductor substrate (1) to form grooves (3), forming a first layer (4) of insulation on the side and bottom surfaces of each of said grooves (3), and a second layer (5) of oxidation-resistance on said first layer (4) and substrate (1);
   b) removing portions of said first layer (4) and second layer (5) which are formed on the side surfaces of said grooves (3) to form windows (6);
   c) forming a third layer with electrically conductive property on said substrate (1) and leaving said third layer only in said grooves (3) to form bit lines (7);
   d) forming a fourth layer (8) of insulation on said bit lines (7);
   e) selectively removing said second layer (5) with said fourth layer (8) used as a mask to form an area in which said substrate (1) is exposed;
   f) forming gate insulation films (9) on said area in which said substrate (1) is exposed;
   g) forming gate electrodes (10) on said respective gate insulation films (9) and doping impurity of a conductivity type opposite to that of said substrate (1) into said substrate (1) with said gate electrodes (10) used as a mask so as to form source/drain regions (11A, 11B);
   h) forming an insulation film (12) which covers the upper surface of said substrate (1), forming windows (13) each of which reaches one (11B) of said source/drain regions in said insulation film (12), and forming storage nodes (14) each connected to said one region (11B) through a corresponding one of said windows (13) on said insulation film (12); and
   i) forming a dielectric film (15) on said storage nodes (14) and forming plate electrodes (16) on said dielectric film (15).

2. A manufacturing method according to claim 1, characterized in that said second layer (5) is a silicon nitride film.

3. A manufacturing method according to claim 1, characterized in that said second layer (5) is a combined film of a silicon nitride film (5) and an oxide film (20).

4. A manufacturing method according to claim 1, characterized in that said fourth layer (8) is formed by thermally oxidizing said bit line (7) with said second layer (5) used as a mask.

5. A manufacturing method according to claim 2, characterized in that said fourth layer (8) is formed by thermally oxidizing said bit line (7) with said second layer (5) used as a mask.

6. A manufacturing method according to claim 3, characterized in that said fourth layer (8) is formed by thermally oxidizing said bit line (7) with said second layer (5) used as a mask.

7. A method of forming an insulation film for insulatively isolating an internal wiring layer of a semiconductor integrated circuit device, characterized by comprising the steps of:

a) forming grooves (3) in the main surface area of a semiconductor substrate (1);

b) forming an oxidation-resistant film (5) on the main surface of said substrate and the side and bottom surfaces of said grooves;

c) filling said grooves (3) with conductive films (7) to form the internal wiring layer of said integrated circuit device; and

d) oxidizing portions of said conductive films (7) which are exposed from said grooves (3) with said oxidation-resistant film (5) used as a mask so as to form insulation films (8).

8. A method according to claim 7, characterized in that said oxidation-resistant film (5) is a silicon nitride film.

F I G. 1

F I G. 2A

F I G. 3A

F I G. 4A

3B    4B

6    6    5

2

6    5    3

2    5    2

3    5

6    5    6

2

5

3B    4B

# F I G. 2B

3    3    5

2

4    1

# F I G. 3B

3    3    5

5    6

2

4    4    1

# F I G. 4B

F I G. 2C

F I G. 3C

F I G. 4C

F I G. 2D

F I G. 3D

F I G. 4D

F I G. 2E

F I G. 3E

F I G. 4E

F I G. 2F

F I G. 3F

F I G. 4F

F I G. 2G

F I G. 3G

F I G. 4G

F I G. 2H

F I G. 5A

F I G. 4H

F I G. 2I

F I G. 6A

F I G. 5B

F I G. 3H

F I G. 4I

FIG. 7C

FIG. 7D

FIG. 7A

FIG. 7B

18

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | US-A-4 912 535 (MITSUBISHI DENKI KABUSHIKI KAISHA) <br> * Figures 10,11,12a-12f; column 8, line 22 - column 9, line 60 <br> * & JP-A-1 042 167, JP-A-1 146 353 | 7,8 | H 01 L 27/108 <br> H 01 L 21/82 |
| Y | | 1-6 | |
| Y | PATENT ABSTRACTS OF JAPAN, vol. 13, no. 86 (E-720)[3434], 28th February 1989; & JP-A-63 263 758 (HITACHI LTD) 31-10-1989 * Whole document * | 1-6 | |
| A | IDEM | 7,8 | |
| Y | US-A-4 918 502 (HITACHI LTD) <br> * Column 3, lines 57-62; figures 8a-8e; column 4, line 30 - column 5, line 6 * | 1-6 | |
| A | | 7,8 | |
| A | PATENT ABSTRACTS OF JAPAN, vol. 12, no. 9 (E-572)[2856], 12th January 1988; & JP-A-62 169 362 AGENCY OF IND. SCIENCE & TECHNOLOGY) 25-07-1987 * Whole document * | 1-8 | |
| A | US-A-3 209 0 (AT&T BELL LAB.) <br> * Figures * | 1-8 | |

TECHNICAL FIELDS SEARCHED (Int. Cl.5)

H 01 L

The present search report has been drawn up for all claims

| Place of search | Date of completion of search | Examiner |
|---|---|---|
| The Hague | 19 June 91 | SINEMUS M. |